# EUROPÄISCHE PATENTSCHRIFT

(11) **EP 1 678 512 B1**
(45) Veröffentlichungstag und Bekanntmachung des Hinweises auf die Patenterteilung: **10.01.2007**
(21) Anmeldenummer: 04790261.4
(22) Anmeldetag: 11.10.2004
(51) Int. Cl.: G01R 19/00, G01R 31/00, G01R 29/08

(54) **VERFAHREN UND VORRICHTUNG ZUR MESSUNG VON FUNKSTÖRPEGELN MIT FREQUENZNACHFÜHRUNG**
METHOD AND DEVICE FOR MEASURING RADIO INTERFERENCE LEVELS WITH FREQUENCY TRACKING
PROCEDE ET DISPOSITIF DE MESURE DE NIVEAUX DE PARASITAGE AVEC ASSERVISSEMENT DE FREQUENCE

(30) Priorität: 27.10.2003 DE 10350063
(43) Veröffentlichungstag der Anmeldung: 12.07.2006
(73) Patentinhaber: Rohde & Schwarz GmbH & Co. KG, 81671 München (DE)
(72) Erfinder: KELLER, Matthias, 85551 Kirchheim (DE)
(74) Vertreter: Körfer, Thomas
(86) Internationale Anmeldenummer: PCT/EP2004/011352
(87) Internationale Veröffentlichungsnummer: WO 2005/047910

(56) Entgegenhaltungen:
- DE-C1- 3 817 500
- US-A- 4 859 933
- US-A- 5 119 018
- US-B1- 6 509 742

## Beschreibung

Die Erfindung betrifft ein Verfahren und eine Vorrichtung zur Messung von Funkstörpegeln.

Die Verwendung immer höherer Übertragungsfrequenzen im Mobilfunk und immer höherer Taktfrequenzen in der Datentechnik stellen zunehmend höhere Anforderungen an die elektromagnetische Verträglichkeit (EMV) vom elektronischen Geräten und Systemen in diesen Anwendungsfeldern. Als wesentliche Voraussetzung für eine optimierte EMVgerechte Auslegung entsprechender elektronischer Geräte und Systeme ist eine hochwertige EMV-Meßtechnik zur präzisen und zuverlässigen Identifizierung und Charakterisierung von auftretenden elektromagnetischen Störungen zu sehen.

Neben einer hohen Meßgenauigkeit in einer hohen Bandbreite bis in den Höchstfrequenzbereich sind vor allen fortgeschrittene Meßfunktionen, wie beispielsweise Signalstatistik, Messung von Leistung und Rauschen im Zeit- und Frequenzbereich, wesentliche Anforderungen an eine hochwertige EMV-Meßtechnik.

Während Spektrum-Analysatoren ihre Stärke in der EMV-Messung hauptsächlich in der schnellen Frequenzmessung bis in den Höchstfrequenzbereich besitzen, liegt der Anwendungsschwerpunkt von Meßempfängern eher in der hoch genauen Berechnung von rechenintensiven Meßfunktionen.

In der systemtechnischen Kombination von Spektrum-Analysator und Meßempfänger in einem EMV-Meßplatz können die jeweiligen Stärken der beiden Geräte in einem System gebündelt werden. In der DE 38 17 500 C1 ist ein derartiges System dargestellt, in dem über eine Spektrum-Analysator-Funktion der gewünschte Frequenzbereich durchgestimmt und bei jeder Meßfrequenz der gemessene Spannungspegel mit einem Grenzwert verglichen und bei Überschreitung des Grenzwertes durch den gemessenen Spannungspegel der zur Meßfrequenz gehörige Spannungspegel als Funkstörspannung gekennzeichnet wird. Sobald eine Funkstörspannung auf diese Weise identifiziert wird, erfolgt eine Umschaltung von der Spektrum-Analysator-Funktion zur Meßempfänger-Funktion. In der Meßempfänger-Funktion wird die Funkstörpannung bei der jeweiligen Meßfrequenz mehrfach hinsichtlich ihres Spannungspegels abgetastet und bei ausgewählter statistischer Bewertungsfunktion hinsichtlich ihres Zeitverhaltens exakter charakterisiert.

US 6,509,742 B offenbart ein Verfahren zur Messung von Funkstörpegeln in einem bestimmten Frequenzbereich anhand einer Vormessung und einer Nachmessung bei der die Mittenfrequenz an die in der vorhergehenden Vormessung ermittelte mittlere Frequenz des Funkstörpegels nachgeführt wird.

Nachteilig an dieser systemtechnischen Kombination von Spektrum-Analysator und Meßempfänger ist insbesondere im Falle einer kontinuierlichen EMV-Messung die Schwierigkeit bei der dynamischen Messung von Funkstörspannungen, deren Frequenzen sich über der Zeit ändern. Derart driftende Funkstörspannungen, wie sie beispielsweise von primär getakteten Schaltnetzteilen erzeugt werden, können somit u. U. relativ schnell aus dem Meßfrequenzbereich des Meßempfängers wandern und gehen damit dem Meßempfänger hinsichtlich einer genaueren Analyse ihres Zeitverhaltens verloren.

Der Erfindung liegt daher die Aufgabe zugrunde, ein Verfahren und eine Vorrichtung zur Messung von Funkstörpegeln derart weiterzuentwickeln, dass in der Vormessung identifizierte und in ihrer Frequenz veränderliche Funkstörpegel in der der Vormessung nachfolgenden Nachmessung richtig erfasst und ausgewertet werden.

Die Aufgabe der Erfindung wird durch ein Verfahren und eine Vorrichtung zur Messung von Funkstörpegeln mit den Merkmalen des Anspruchs 1 bzw. des Anspruchs 5 gelöst. Indem der Spektrum-Analysator im Rahmen der Vormessung sich mit seiner Mittenfrequenz auf die Frequenz der jeweiligen Funkstörspannung abstimmt und diese Frequenzabstimmung des Spektrum-Analysators vom Messempfänger in der Nachmessung übernommen wird, ist gewährleistet, dass der beschränkte Messfrequenzbereich des Messempfängers an die geänderte Frequenz der jeweiligen Funkstörspannung jeweils nachgeführt wird und die jeweils identifizierte Funkstörstörung innerhalb des Messfrequenzbereiches des Messeempfängers im Hinblick auf eine korrekte Zeitanalyse zu liegen kommt.

Vorteilhafte Ausgestaltungen der Erfindung sind in den abhängigen Ansprüchen angeben.

Neben der korrekten Erfassung einer Frequenzdrift der Funkstörspannung kann das erfindungsgemäße Verfahren bzw. die erfindungsgemäße Vorrichtung zur Messung von Funkstörspannungen auch zeitliche Änderungen der Spannungspegels der Funkstörspannung korrekt identifizieren, und bei der Frequenznachführung des Meßempfängers korrekt berücksichtigen. Auf diese Weise ist eine korrekten,Erfassung und Auswertung von frequenz- und amplitudenveränderlichen Funkstörspannungen durch das erfindungsgemäße Verfahren bzw. durch die erfindungsgemäße Vorrichtung zur Messung von Funkstörspannungen möglich.

In dem Meßempfänger sind vorzugsweise mehrere auswählbare Bewertungsfunktionen integriert, mit denen in der Nachmessung eine exaktere Analyse des Zeitverhaltens der Funkstörspannung über eine gegenüber der Messzeit des Spektrum-Analysators deutlich längeren Auswertezeit möglich ist.

Das erfindungsgemäße Verfahren bzw. die erfindungsgemäße Vorrichtung zur Messung von Funkstörspannungen ist nicht nur für eine einzige Funkstörspannung ausgelegt, sondern ermöglicht die gleichzeitige Identifizierung von mehreren Funkstörspannungen mit Hilfe des Spektrum-Analysators im Rahmen einer Vormessung und die anschließende Auswertung aller identifizierten Funkstörspannungen mit Hilfe des Messempfängers in der Nachmessung.

Eine bevorzugte Ausführungsform der Erfindung ist in der Zeichnung dargestellt und wird nachfolgend näher beschrieben. Es zeigen:
- Fig. 1: ein Schaltbild eines Ausführungsbeispiels einer erfindungsgemäßen Vorrichtung zur Messung von Funkstörspannungen;
- Fig. 2: ein Flußdiagramm des erfindungsgemäßen Verfahrens zur Messung von Funkstörspannungen und
- Fig. 3: eine grafische Darstellung eines beispielhaften Ergebnisses des erfindungsgemäßen Verfahrens bzw. einer erfindungsgemäßen Vorrichtung zur Messung von Funkstörspannungen.

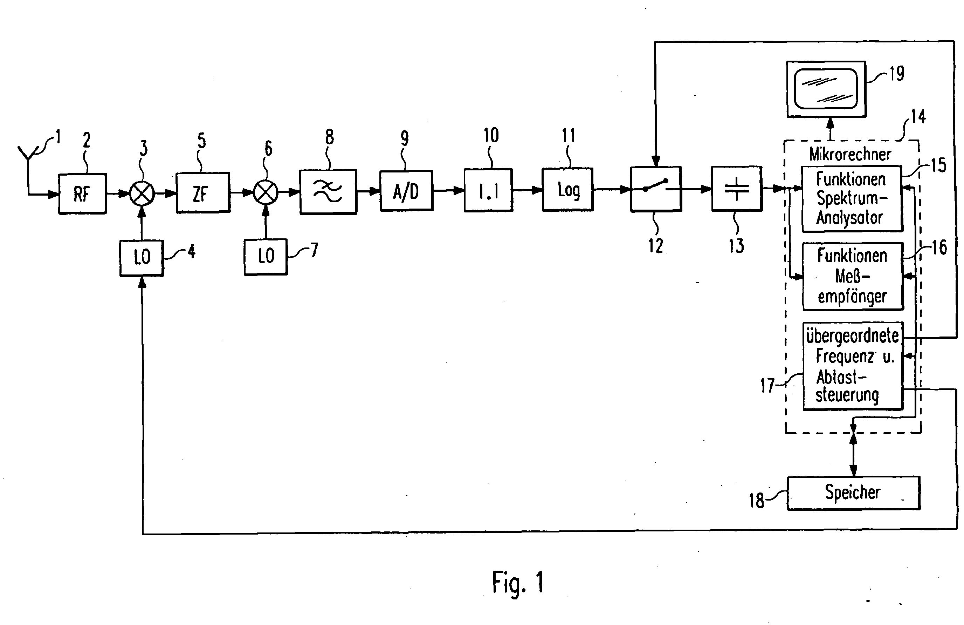

Das erfindungsgemäße Verfahren bzw. die erfindungsgemäße Vorrichtung zur Messung von Funkstörspannungen ist in den Figuren 1 bis 3 dargestellt.

In dieser Anmeldung wurden die Begriffe Funkstörspannung und Meßspannung im Sinne von Funkstörpegel und Meßpegel allgemeingültig verwendet. Gemeint sind nicht nur die Spannung im engeren Sinne als Meßgröße, sondern auch andere Meßgrößen wie Feldstärke, Ströme usw., die das Meßsignal kennzeichnen. Der Begriff Spannung, Meßspannung, Funkstörspannung usw. kann daher beliebig durch Pegel, Meßpegel bzw. Funkstörpegel ersetzt werden.

Wie in Fig. 1 dargestellt, wird über eine Antenne 1 der erfindungsgemäßen Vorrichtung zur Messung von Funkstörspannungen, die an einem bestimmten auswählbaren Meßort positioniert ist, jedes beliebige Nutz- und/oder Störsignal empfangen. Unter der Voraussetzung, dass die erfindungsgemäße Vorrichtung zur Messung von Funkstörspannungen an einem Meßort positioniert ist, an dem keine Nutzsignale auftreten, wird von der Antenne 1 im ungestörten Betriebsfall nur ein Rauschsignal empfangen. Bei Auftreten einer Funkstörung wird diese von einem Hochfrequenzteil 2 über die Antenne 1 empfangen.

Im sich anschließenden ersten Mischer 3 erfolgt eine Umsetzung auf die Zwischenfrequenz. Hierzu wird ein in seiner Frequenz verstimmbarer erster lokaler Oszillator 4 über den gesamten Meßfrequenzbereich der erfindungsgemäßen Vorrichtung vorzugsweise in einem bestimmten einstellbaren Frequenzraster durchgestimmt. Mit diesem in einem bestimmten Frequenzraster innerhalb des vorgegebenen Meßfrequenzbereiches durchgestimmten ersten lokaler Oszillator 4 wird im ersten Mischer 3 das Frequenzspektrum der empfangenen hochfrequenten Funkstörspannung zusammen mit der überlagerten hochfrequenten Rauschspannung in einen Zwischenfrequenzbereich umgesetzt.

In der Zwischenfrequerizeinheit 5 erfolgen mit dem Zwischenfrequenzsignal unterschiedliche Signalverarbeitungsfunktionen (z.B. Filterung, Linearisierung usw.). Die Umsetzung des Zwischenfrequenzsignals in das Basisband wird im darauf folgenden zweiten Mischer 6 durchgeführt. Die Trägerfrequenz zur Umsetzung in das Basisband wird von einem zweiten lokalen Oszillator 7 mit fixer Frequenz erzeugt.

In einem sich anschließenden Tiefpassfilter 8 erfolgt eine Bereinigung des Basisbandsignals von unerwünschten höherfrequenten Anteilen, die außerhalb des Meßfrequenzbereiches bzw. evtl. ausgewählter Untermeßfrequenzbereiche liegen. Im Analog-/Digital-Wandler 9 wird die analoge Meßspannung in das digitale Datenformat transformiert. Die Betragsbildung der digitalisierten zeitveränderlichen Meßspannung wird im Betragsbildner 10 durchgeführt. Eine Logarithmierung der digitalisierten zeitveränderlichen Meßspannung für eine halblogarithmische Darstellung des Messergebnisses erfolgt im Logarithmierer 11.

Der Zugriff auf das Signal ist durch den symbolischer Schalter 12 veranschaulicht. Hierzu erhält der Schalter 12 von einer übergeordneten Steuerung 17 ein Steuersignal, das den Zeitpunkt des Zugriffs bestimmt. Der digitalisierte Spannungspegel der Meßspannung wird während des Zugriffs in einem Detektor 13 erfaßt.

Der mit dem Detektor 13 erfaßte digitalisierte Spannungspegel der Meßspannung wird vom Mikrorechner 14 eingelesen. Mittels der Funktionseinheit Spektrum-Analysator 15 des Mikrorechner 14 wird die aus der Funkstörspannung und der überlagerten Rauschspannung bestehende Meßspannung über den gesamten einstellbaren Messfrequenzbereich im einstellbaren Frequenzraster gemessen. Hierzu wird durch die übergeordnete Frequenz- und Abtaststeuereinheit 17 des Mikrorechners 14 die Frequenz des ersten Oszillators 4 über den einstellbaren Messfrequenzbereich im einstellbaren Frequenzraster im Hinblick auf die Aufnahme des Frequenzspektrums der Meßspannung sukzessive durchgestimmt. Der zur Geschwindigkeit der Frequenzdurchstimmung synchrone Zugriff auf die digitale Meßspannung über die erste Meßzeit erfolgt ebenfalls durch die übergeordnete Frequenz- und Abtaststeuereinheit 17. In der Funktionseinheit Spektrum-Analysator 15 erfolgt auch der Vergleich des pro Meßfrequenz gemessenen Spannungspegels in Relation zu einem einstellbaren Grenzwert und die Kennzeichnung des gemessenen Spannungspegels als Funkstörspannung im Falle eines Überschreitens des Grenzwertes durch den gemessenen Spannungspegel. Die zu den einzelnen Meßfrequenzen innerhalb des Meßfrequenzbereiches erfaßten Spannungspegel des Meßsignals inklusive der identifizierten Funkstörspannungspegel werden im Speicher 18 zwischengespeichert.

Durch eine im Mikrorechner 14 integrierte übergeordnete Ablaufsteuerung, die in Fig. 1 nicht dargestellt ist, wird nach Ablauf der Vermessung des Frequenzspektrums der Meßspannung im gesamten Meßfrequenzbereich durch die Funktionseinheit Spektrum-Analysator 15 der Betrieb auf die Funktionseinheit Meßempfänger 16 umgeschaltet. In einem Meßfrequenzbereich der Funktionseinheit Meßempfänger 16, der im allgemeinen kleiner als der einstellbare Meßfrequenzbereich der Funktionseinheit Spektrum-Analysator 15 ist, findet in der Funktionseinheit Meßempfänger 16 eine genauere Analyse des Zeitverhaltens der einzelnen, identifizierten Funkstörspannungen über mehrere Zugriffszeitpunkte im Rahmen einer zweiten Meßzeit statt. Die Meß- und Auswertungsergebnisse der Funktionseinheit Meßempfänger 16 werden ebenfalls im Speicher 18 zwischengespeichert.

Sämtliche Meßergebnisse werden in einer Darstellungseinrichtung 19, z. B. einem Display, in grafische Form zur Visualisierung und nachfolgenden Ergebnisdiskussion bereitgestellt.

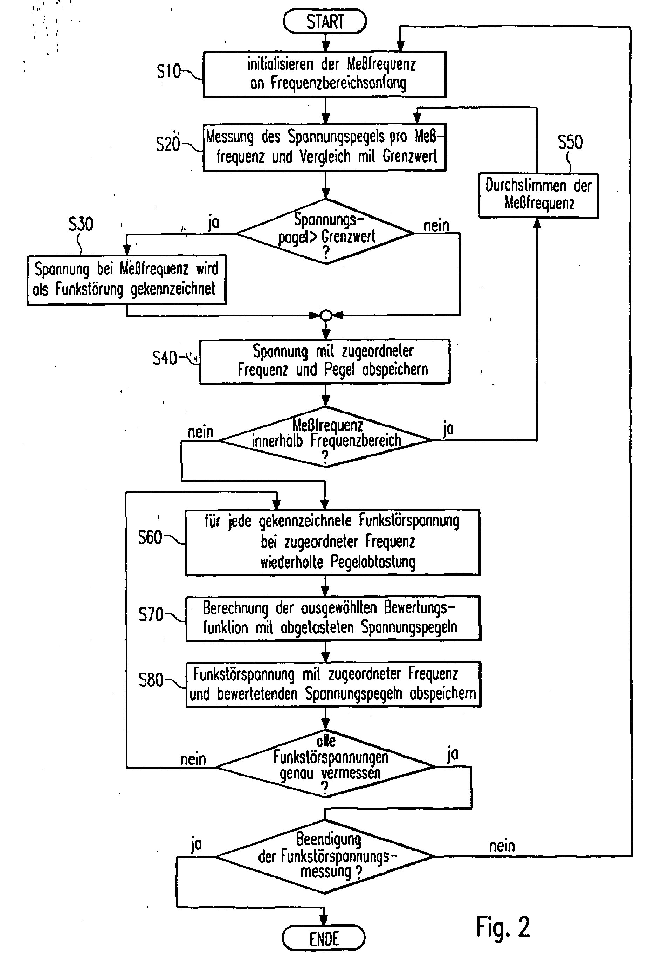

Das erfindungsgemäße Verfahren zur Messung von Funkstörspannungen, dessen Verfahrensschritte im Flußdiagramm in Fig. 2 dargestellt sind, führt in der beginnenden Vormessung, die von der Funktionseinheit Spektrum-Analysator 15 durchgeführt wird, im ersten Verfahrensschritt S10 eine Initialisierung der Meßfrequenz der erfindungsgemäßen Vorrichtung nach Fig. 1 z. B. mit der vom Anwender gewählten unteren Grenzfrequenz des zu vermessenden-Meßfrequenzbereiches durch.

Im darauf folgenden Verfahrensschritt S20 wird bei der gewählten Meßfrequenz der Spannungspegel des aus der Funkstörspannung und überlagerter Rauschspannung bestehenden Meßspannung innerhalb einer ersten Meßzeit erfasst. Der jeweils gemessene Spannungspegel wird im Verfahrensschritt S20 mit einem vom Anwender gewählten Grenzwert verglichen. Bei dem Grenzwert handelt es sich üblicherweise um einen über den ganzen Meßfrequenzbereich konstanten Wert, der im Sinne eines Markers über den gesamten Meßfrequenzbereich gelegt wird. Prinzipiell ist aber auch die Verwendung eines über den gesamten Meßfrequenzbereich veränderlichen Grenzwertverlaufs möglich.

Überschreitet der bei der jeweiligen Meßfrequenz gemessene Spannungspegel der Meßspannung den Grenzwert, so wird die Meßspannung bei dieser Meßfrequenz als Funkstörspannung gekennzeichnet und die eingestellte Meßfrequenz als Mittenfrequenz für eine spätere Nachmessung festgelegt. Liegt eine Überschreitung des Grenzwertes durch die Meßspannung über einen bestimmten Frequenzbereich im Falle einer breitbandigen Funkstörspannung vor, so wird von der Funktionseinheit Spektrum-Analysator 15 die jeweilige mittlere Frequenz ermittelt und als Mittenfrequenz festgelegt.

Alle im Verfahrensschritt S20 zu den einzelnen Meßfrequenzen gemessenen Spannungen werden mit ihren dazugehörigen Spannungspegeln und Frequenzen sowie im Falle einer Grenzwertüberschreitung mit ihrer Mittenfrequenz und mit der Kennzeichnung als Funkstörspannung im Verfahrensschritt S30 abgespeichert.

Liegt der Wert der Meßfrequenz unterhalb der vom Anwender ausgewählten oberen Grenzfrequenz des zu vermessenden Meßfrequenzbereiches, so wird die Meßfrequenz um einen Frequenzrasterinkrement erhöht und mit der neuen Meßfrequenz in Verfahrensschritt S20 eine neue Pegelmessung durchgeführt. Alternativ kann aber auch eine kontinuierliche (gesweepte) Messung durchgeführt werden.

Hat die eingestellte Meßfrequenz die vom Anwender ausgewählte obere Grenzfrequenz des zu vermessenden Meßfrequenzbereiches erreicht, so ist die Vormessung in der Funktionseinheit Spektrum-Analysator 15 beendet. Das Verfahren geht nun über in die Betriebsart Nachmessung, die von der Funktionseinheit Meßempfänger 16 durchgeführt wird.

Für jede der in der Vormessung von der Funktionseinheit Spektrum-Analysator 15 gekennzeichneten Funkstörspannungen erfolgt im Verfahrenschritt S60 eine über eine bestimmte einstellbare Anzahl von Zugriffszeitpunkten sich erstreckkende zweite Meßzeit, die deutlich länger als die erste Meßzeit der Funktionseinheit Spektrum-Analysator 15 ist, eine Messung des Spannungspegels der Meßspannung. Hierbei wird der Meßfrequenzbereich der Funktionseinheit Meßempfänger 16 so gewählt, daß die von der Funktionseinheit Spektrum-Analysator 15 für jede gekennzeichnete Funkstörspannung ermittelte Mittenfrequenz als Mittenfrequenz des jeweiligen Meßfrequenzbereichs für die Nachmessung benutzt wird. Aufgrund der zyklischen Wiederholung von Nach- und Vormessung wird somit die Mittenfrequenz der Nachmessung auf die in der Vormessung identifizierte Mittenfrequenz der gekennzeichneten Funkstörspannung nachgeführt, womit eine dynamische Messung einer frequenzveränderlichen Funkstörspannung möglich ist.

Im darauf folgenden Verfahrensschritt S70 wird mit einer vom Anwender auswählbaren Berechnungsfunktion auf der Basis der zu den einzelnen Zugriffszeitpunkten gemessenen Spannungspegel der Meßspannung eine genauere Analyse des Zeitverhaltens der Funkstörspannung durchgeführt. Diese Analyse erstreckt sich auf den Meßfrequenzbereich der Funktionseinheit Meßempfänger 16 mit der von der Funktionseinheit-Spektrum-Analysatoren 15 ermittelten Mittenfrequenz der jeweiligen Funkstörspannung als Mittenfrequenz des Meßfrequenzbereiches. Als Bewertungsfunktionen können hierbei beispielsweise folgende Funktionen vom Anwender ausgewählt werden:
- Sample-Funktion: Identifizierung des augenblicklichen Spannungspegels der Funkstörspannung
- Max-peak-Funktion: Identifizierung des maximalen Spannungspegel der Funkstörstörung
- Min-peak-Funktion: Identifizierung des minimalen Spannungspegel ist der Funkstörspannung
- Quasi-peak-Funktion: Bewertung, die das Störvermögen des Signals bewertet
- Average-Funktion: lineares Mitteln der abgetasteten Spannungspegel der Funkstörspannung
- RMS-Funktion: quadratisches Mitteln der abgetasteten Spannungspegel der Funkstörspannung

Im Verfahrensschritt S80 werden für alle Meßfrequenzen innerhalb des zur jeweiligen Funkstörspannung gehörigen Meßfrequenzbereiches der Funktionseinheit Meßempfänger 16 die durch die jeweils ausgewählten Bewertungsfunktionen ermittelten Spannungspegelfunktionswerte als Ergebnisse einer genaueren Zeitanalyse der Funkstörspannung abgespeichert.

Sind noch nicht alle von der Funktionseinheit Spektrum-Analysator 15 gekennzeichneten Funkstörspannungen im Rahmen der Nachmessung von der Funktionseinheit Meßempfänger 16 genau vermessen, so erfolgt im Verfahrensschritt S60 für die nächste noch nicht in der Nachmessung vermessene Funkstörspannung eine genauere Vermessung des Zeitverhaltens, indem die Mittenfrequenz des Meßfrequenzbereiches der Funktionseinheit Meßempfänger 16 auf die von der Funktionseinheit Spektrum-Analysator 15 ermittelten Mittenfrequenz der im Folgenden zu vermessenden Funkstörpannung eingestellt wird und eine wiederholte Abtastung der Spannungspegel der zu vermessenden Funkstörspannung im eingestellten Meßfrequenzbereich der Funktionseinheit Meßempfänger 16 durchgeführt wird.

Sind alle von der Funktionseinheit Spektrum-Analysator 15 in der Vormessung gekennzeichneten Funkstörspannungen von der Funktionseinheit Meßempfänger 16 in der Nachmessung genauer vermessen und analysiert, so wird das erfindungsgemäße Verfahren zur Messung von Funkstörspannungen von der übergeordneten Ablaufsteuerung wieder auf die Vormessung durch die Funktionseinheit Spektrum-Analysator 15 umgeschaltet, falls vom Anwender keine Beendigung der EMV-Messung beabsichtigt wird. In der sich nun wiederholenden Vormessung wird im Verfahrensschritt S10 die Meßfrequenz des Spektrum-Analysators entsprechend der unteren Grenzfrequenz des zu vermessenden Meßfrequenzbereiches eingestellt.

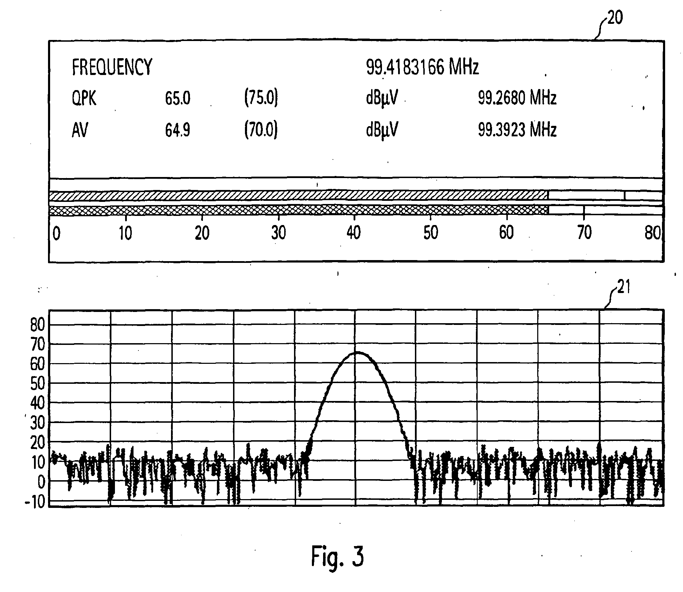

In Fig. 3 ist ein beispielhaftes Meßergebnis einer Messung der Funkstörspannung, wie sie auf einer Darstellungseinrichtung 19 dargeboten wird, dargestellt. Im oberen Bereich 20 der Darstellung, der den Ergebnissen der Nachmessung reserviert ist, werden bei einer ermittelten Mittenfrequenz von im Beispiel ca. 99,4 MHz für eine identifizierte Funkstörspannung die Spannungspegelwerte und Frequenzwerte bei Verwendung der Quasi-Peak- und der Average-Funktion als Bewertung dargestellt. Im unteren Bereich 21 der Darstellung ist das Frequenzspektrum der Funkstörspannung inklusive der benachbarten Rauschspannung im Meßfrequenzbereich der Funktionseinheit Spektrum-Analysatoren 15 mit der ermittelten Mittenfrequenz der Funkstörspannung als Mittenfrequenz des verwendeten Meßfrequenzbereiches dargestellt. Analog können für die übrigen identifizierten Funkstörspannungen die Ergebnisse der Vor- und Nachmessung dargestellt werden. In dem unteren Bereich 21 könnten auch der spektrale Verlauf der Bewertungsfunktion, im Beispiel Quasi-Peak und Average, zusätzlich dargestellt werden.

Wesentlich ist, daß bei jeder Nachmessung eine Frequenznachführung erfolgt. Dabei wird bei einer Nachmessung dann ein neuer Maximalwert gespeichert bzw. der bisher gespeicherte Maximalwert überschrieben, wenn dieser größer als alle bisher erfaßten Maximalwerte ist. Zusätzlich wird der zu diesem neuen Maximalwert gehörende Frequenzwert gespeichert.

Die Erfindung ist nicht auf das beschriebene Ausführungsbeispiel beschränkt. Sämtliche beschriebene Funktionen und Elemente können beliebig miteinander kombiniert werden.

## Patentansprüche

1. Verfahren zur Messung von Funkstörpegeln in einem bestimmten Frequenzbereich, indem in einer Vormessung der Frequenzbereich durchgestimmt wird, bei jeder Meßfrequenz jeweils ein Meßpegel des zu vermessenden Signals erfaßt und mit einem Grenzwert verglichen wird und bei Überschreitung des Grenzwertes durch den Meßpegel der bei der jeweiligen Meßfrequenz gemessene Pegel als Funkstörpegel **gekennzeichnet** wird und in einer Nachmessung jeder **gekennzeichnet**e Funkstörpegel jeweils hinsichtlich seines Zeitverhaltens genauer vermessen wird,
**dadurch gekennzeichnet,**
**daß** zur Erfassung einer Frequenzdrift für jeden **gekennzeichnet**e Funkstörpegel die Mittenfrequenz des Meßfrequenzbereichs der Nachmessung, die sich zyklisch im Wechsel mit der Vormessung wiederholt, an die in der vorhergehenden Vormessung neu ermittelte mittlere Frequenz des sich ändernden Funkstörpegels nachgeführt wird.

2. Verfahren zur Messung von Funkstörpegeln nach Anspruch 1,
**dadurch gekennzeichnet,**
**daß** in jeder sich zyklisch im Wechsel mit der Nachmessung wiederholenden Vormessung der Meßpegel jedes sich gegenüber der vorhergehenden Vormessung in seiner Frequenz und/oder seinem Meßpegel verändernden Funkstörpegels bestimmt wird.

3. Verfahren zur Messung von Funkstörpegeln nach Anspruch 1 oder 2,
**dadurch gekennzeichnet,**
**daß** der Frequenzbereich bei der Vormessung in einem bestimmten Frequenzraster durchgestimmt wird.

4. Verfahren zur Messung von Funkstörpegeln nach einem der Ansprüche 1 bis 3,
**dadurch gekennzeichnet,**
**daß** der Meßpegel des jeweiligen Funkstörpegels in einer zweiten Meßzeit der Nachmessung gegenüber einer ersten Meßzeit der Vormessung mehrfach wiederholt gemessen wird.

5. Verfahren zur Messung von Funkstörpegeln nach Anspruch 4,
**dadurch gekennzeichnet,**
**daß** aus den bei der Nachmessung mehrfach abgetasteten Meßpegeln für jeden **gekennzeichnet**en Funkstörpegel ein nach einem aus mehreren einstellbaren Bewertungsverfahren bewerteter Pegel ermittelt werden.

6. Vorrichtung zur Messung von Funkstörpegeln nach einem der Ansprüche 1 bis 4,
wobei die Vorrichtung eine Funktionseinheit Spektrum-Analysator (15) zur Identifizierung der Funkstörpegel und zur Ermittlung der mittleren Frequenz der identifizierten Funkstörpegel im Rahmen einer Vormessung, eine Funktionseinheit Meßempfänger (16) zur mehrfachen Abtastung der Meßpegel der von der Funktionseinheit Spektrum-Analysator (15) identifizierten Funkstörpegel und zur statistischen Bewertung der abgetasteten Meßpegel im Rahmen einer Nachmessung und einen Microrechner aufweist, der dazu eingerichtet ist, die Vorrichtung so zu steuern, dass alle Merkmale des Anspruchs 1 durchgeführt werden.

## Claims

1. Method for measuring radio-interference levels within a given frequency range, wherein the frequency range is adjusted in a pre-measurement;
wherein a measuring level of the signal to be measured is registered at each measuring frequency and compared with a limit value; wherein the level measured at the respective measuring frequency is marked as the radio-interference level, if the limit value is exceeded by the measuring level, and
wherein each marked radio-interference level is measured more accurately with regard to its respective runtime performance in a post-measurement
**characterised in that**,
the mid-frequency of the measuring-frequency range of the post-measurement, which is repeated cyclically in alternation with the pre-measurement, is tracked, for each marked radio-interference level, to the mean frequency of the changing radio-interference level just determined in the preceding pre-measurement.

2. Method for measuring radio-interference levels according to claim 1,
**characterised in that**,
the measuring level of each radio-interference level, which varies relative to the preceding pre-measurement with regard to its frequency and/or its measuring level, is determined in each pre-measurement, which is repeated cyclically in alternation with the post-measurement.

3. Method for measuring radio-interference levels according to claim 1 or 2,
**characterised in that**
the frequency range in the pre-measurement is adjusted within a given frequency grid.

4. Method for measuring radio-interference levels according to any one of claims 1 to 3,
**characterised in that**,
the measuring level of the respective radio-interference level is measured in a second measuring runtime of the post-measurement several times repeatedly by comparison with a first measuring runtime of the pre-measurement.

5. Method for measuring radio-interference levels according to claim 4,
**characterised in that**
a level evaluated according to one of several variable evaluation methods is determined from the measured levels for each marked radio-interference level sampled repeatedly in the post-measurement.

6. Device for measuring radio-interference levels according to any one of claims 1 to 4,
wherein the device comprises a functional spectrum-analyser unit (15) for identifying radio-interference levels and determining the mean frequency of the identified radio-interference levels within the context of a pre-measurement; a functional measurement-receiver unit (16) for the multiple sampling of the measuring level of the radio-interference level identified by the functional spectrum-analyser unit (15) and for statistical evaluation of the sampled measuring levels within the context of a post-measurement; and a microcomputer, which is set up to control the device in such a manner that all of the features of claim 1 are implemented.

## Revendications

1. Procédé de mesure de niveaux de parasitage de liaisons hertziennes dans une plage de fréquences déterminée, dans lequel la plage de fréquence est déterminée lors d'une mesure préliminaire, un niveau de mesure du signal à mesurer est respectivement détecté pour chaque fréquence de mesure et est comparé avec une valeur limite, et en cas de dépassement de la valeur limite par le niveau de mesure, le niveau mesuré à la fréquence de mesure respective est identifié comme niveau de parasitage de liaisons hertziennes et dans lequel lors d'une mesure ultérieure chaque niveau de parasitage de liaisons hertziennes identifié fait l'objet d'une mesure plus précise respectivement en ce qui concerne son comportement dans le temps, **caractérisé en ce que**, pour la détection d'une dérive de fréquence pour chaque niveau de parasitage de liaisons hertziennes identifié, la fréquence centrale de la plage de fréquences de mesure de la mesure ultérieure, laquelle se répète de manière cyclique en alternance avec la mesure préliminaire, est repositionnée par rapport à la fréquence moyenne déterminée à nouveau au cours de la mesure préliminaire précédente du niveau de parasitage de liaisons hertziennes variable.

2. Procédé de mesure de niveaux de parasitage de liaisons hertziennes selon la revendication 1, **caractérisé en ce que**, lors de chaque mesure préliminaire qui se répète de manière cyclique en alternance avec la mesure ultérieure, on exécute la détermination du niveau de mesure de chaque niveau de parasitage de liaisons hertziennes dont la fréquence et/ou le niveau de mesure change par rapport à la mesure préliminaire précédente.

3. Procédé de mesure de niveaux de parasitage de liaisons hertziennes selon la revendication 1 ou 2, **caractérisé en ce que**, lors de la mesure préliminaire, la plage de fréquence est réglée en continu et successivement dans une trame de fréquences déterminée.

4. Procédé de mesure de niveaux de parasitage de liaisons hertziennes selon l'une quelconque des revendications 1 à 3, **caractérisé en ce que** le niveau de mesure du niveau de parasitage de liaisons hertziennes respectif est mesuré en répétant plusieurs fois lors d'un deuxième temps de mesure de la mesure ultérieure par rapport à un premier temps de mesure de la mesure préliminaire.

5. Procédé de mesure de niveaux de parasitage de liaisons hertziennes selon la revendication 4, **caractérisé en ce qu'**à partir des niveaux de mesure qui font l'objet d'une exploration multiple lors de la mesure ultérieure, un niveau qui est évalué d'après un procédé d'évaluation réglable parmi plusieurs est déterminé pour chaque niveau de parasitage de liaisons hertziennes identifié.

6. Dispositif de mesure de niveaux de parasitage de liaisons hertziennes selon l'une quelconque des revendications 1 à 4, **caractérisé en ce que** le dispositif comprend une unité fonctionnelle formée par un analyseur de spectre (15) servant dans le cadre d'une mesure préliminaire à l'identification des niveaux de parasitage de liaisons hertziennes et à la détermination de la fréquence moyenne des niveaux de parasitage de liaisons hertziennes identifiés, une unité fonctionnelle formée par un récepteur de mesure (16) servant à réaliser une exploration multiple des niveaux de mesure des niveaux de parasitage de liaisons hertziennes identifiés par l'unité fonctionnelle formée par l'analyseur de spectre (15) et à réaliser dans le cadre d'une mesure ultérieure une évaluation statistique des niveaux de mesure explorés et un microcalculateur qui est configuré pour commander le dispositif de façon à ce que toutes les caractéristiques du procédé de la revendication 1 soient mises en oeuvre.
